# EUROPEAN PATENT APPLICATION

(11) **EP 2 293 347 A2**
(43) Date of publication of application: **09.03.2011**
(21) Application number: 10174913.3
(22) Date of filing: 01.09.2010
(51) Int. Cl.: H01L 31/052, H01L 31/075

(54) **Photovoltaic device and method for manufacturing the same**

(30) Priority: 02.09.2009 KR 20090082355
(71) Applicant: KISCO, Changwon-si Gyeongsangnam-do 641-370 (KR)
(72) Inventor: Myong, Seung-Yeop, 156-831, Seoul (KR)
(74) Representative: Ferreccio, Rinaldo

(57) **Abstract**

Disclosed is a photovoltaic device. The photovoltaic device includes a substrate; a first unit cell disposed on the substrate and comprising a p-type window layer, an i-type photoelectric conversion layer and an n-type layer; an intermediate reflector disposed on the first unit cell and comprising a hydrogenated n-type microcrystalline silicon carbide or a hydrogenated n-type microcrystalline silicon nitride profiled such that carbon concentration or nitride concentration is higher the farther it is from a light incident side; and a second unit cell (50) disposed on the intermediate reflector (40) and comprising a p-type window layer (50p), an i-type photoelectric conversion layer (50i) and an n-type layer (50n).

## Description

### Field

This embodiment relates to a photovoltaic device and a method for manufacturing the same.

### Description of the Related Art

Recently, because of a high oil price and a global warming phenomenon based on a large amount of CO₂ emission, energy is becoming the most important issue in determining the future life of mankind. Even though many technologies using renewable energy sources including wind force, bio-fuels, a hydrogen/fuel cell and the like have been developed, a photovoltaic device using sunlight is in the spotlight in that solar energy, the origin of all energies, is an almost infinite clean energy source.

The sunlight incident on the surface of the earth has an electric power of 120,000 TW. Thus, theoretically, if a photovoltaic device having a photoelectric conversion efficiency of 10% covers only 0.16% of the land surface of the earth, it is possible to generate electric power of 20 TW that is twice as much as the amount of energy globally consumed during one year.

Practically, the world photovoltaic market has explosively grown by almost 40% of an annual growth rate for the last ten years. Now, a bulk-type silicon photovoltaic device occupies a 90% of the photovoltaic device market share. The bulk-type silicon photovoltaic device includes a single-crystalline silicon photovoltaic device and a multi-crystalline or a poly-crystalline silicon photovoltaic device and the like. However, productivity of a solar-grade silicon wafer which is the main material of the photovoltaic device is not able to fill the explosive demand thereof, so the solar-grade silicon wafer is globally in short supply. Therefore, this shortage of the solar-grade silicon wafer is a huge threatening factor in reducing the manufacturing cost of a photovoltaic device.

Contrary to this, a thin-film silicon photovoltaic device including a light absorbing layer based on a hydrogenated amorphous silicon (a-Si:H) allows to reduce a thickness of a silicon layer equal to or less than 1/100 as large as that of a silicon wafer of the bulk-type silicon photovoltaic device. Also, it makes possible to manufacture a large area photovoltaic device at a lower cost.

Meanwhile, a single-junction thin-film silicon photovoltaic device is limited in its achievable performance. Accordingly, a double junction thin-film silicon photovoltaic device or a triple junction thin-film silicon photovoltaic device having a plurality of stacked unit cells has been developed, pursuing high stabilized efficiency.

The double junction or the triple junction thin-film silicon photovoltaic device is referred to as a tandem-type photovoltaic device. The open circuit voltage of the tandem-type photovoltaic device corresponds to a sum of each unit cell's open circuit voltage. Short circuit current is determined by a minimum value among the short circuit currents of the unit cells.

Regarding the tandem-type photovoltaic device, research is being devoted to an intermediate reflector which is capable of improving efficiency by enhancing internal light reflection between the unit cells.

### Summary

One aspect of this invention is a photovoltaic device. The photovoltaic device includes a substrate; a first unit cell disposed on the substrate and comprising a p-type window layer, an i-type photoelectric conversion layer and an n-type layer; an intermediate reflector disposed on the first unit cell and comprising a hydrogenated n-type microcrystalline silicon carbide or a hydrogenated n-type microcrystalline silicon nitride profiled such that carbon concentration or nitride concentration is higher the farther it is from a light incident side; and a second unit cell disposed on the intermediate reflector and comprising a p-type window layer, an i-type photoelectric conversion layer and an n-type layer.

Another aspect of this invention is a method for manufacturing a photovoltaic device. The method includes forming a plurality of first electrodes on a substrate; forming a first unit cell layer comprising a p-type window layer, an i-type photoelectric conversion layer and an n-type layer on the plurality of the first electrodes; forming an intermediate reflector on the first unit cell layer, the intermediate reflector comprises a hydrogenated n-type microcrystalline silicon carbide or a hydrogenated n-type microcrystalline silicon nitride profiled such that carbon concentration or nitride concentration is higher the farther it is from a light incident side; and forming a second unit cell layer on the intermediate reflector.

Further another aspect of this invention is a method for manufacturing a photovoltaic device. The method includes forming a plurality of first electrodes on a substrate; forming a first unit cell layer comprising a p-type window layer, an i-type photoelectric conversion layer and an n-type layer on the plurality of the first electrodes; forming an intermediate reflective layer by diffusing carbon or nitrogen into the n-type layer of the first unit cell layer, the intermediate reflective layer comprising a hydrogenated n-type micro crystalline silicon carbide or a hydrogenated n-type micro crystalline silicon nitride profiled such that carbon concentration or nitrogen concentration is higher the farther it is from a light incident side; and forming a second unit cell layer on the intermediate reflector.

### Brief description of the drawings

Fig. 1 is a cross sectional view showing a structure of a photovoltaic device according to an embodiment of the present invention.
Figs. 2a and 2b show a method for manufacturing the photovoltaic device according to an embodiment of the present invention.
Figs. 3a and 3b show a method for manufacturing the photovoltaic device according to another embodiment of the present invention.

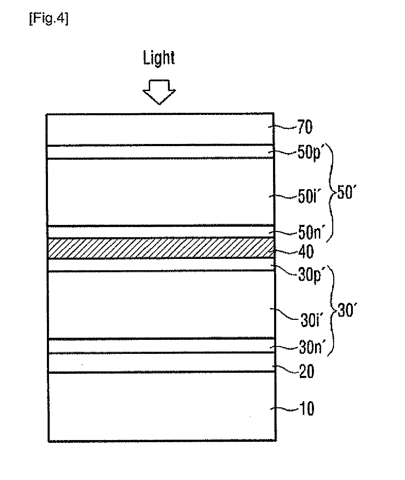

Fig. 4 shows a photovoltaic device according to another embodiment of the present invention.

### Detailed description of embodiments

A photovoltaic device according to an embodiment of the present invention and a method for manufacturing the photovoltaic device will be described with reference to the drawings.

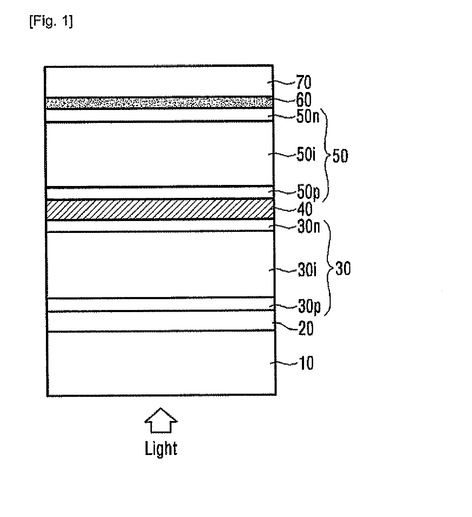

A photovoltaic device may have a double junction structure and a triple junction structure and the like. In Fig.1, a photovoltaic device having the double junction structure will be described as an example.

As shown in Fig. 1, a photovoltaic device according to an embodiment of the present invention includes a substrate 10, a first electrode 20, a first unit cell 30, an intermediate reflector 40, a second unit cell 50 and a second electrode 70. In the embodiment of the present invention, the substrate 10 may include an insulating transparent material such as glass.

The first electrode 20 is formed on the substrate 10 and may include transparent conducting oxide (TCO) such as ZnO.

The first unit cell 30 is placed on the first electrode 20. The first unit cell 30 includes a p-type window layer 30p, an i-type photoelectric conversion layer 30i and an n-type layer 30n. They are formed by plasma chemical vapor deposition (CVD) method.

The intermediate reflective layer 40 is placed on the first unit cell 30 and includes a hydrogenated n-type microcrystalline silicon carbide (n-µc-SiC:H) or a hydrogenated n-type micro crystalline silicon nitride (n-pc-SiN:H). Here, the intermediate reflector 40 is profiled such that carbon concentration or nitrogen concentration is higher the farther it is from a light incident side, in this case, from the substrate 10 and the first unit cell 30.

The second unit cell 50 is placed on the intermediate reflector 40 and includes a p-type window layer 50p, an i-type photoelectric conversion layer 50i and an n-type layer 50n. They are formed by plasma chemical vapor deposition (CVD) method. The second unit cell 50 may include a hydrogenated amorphous silicon or a hydrogenated microcrystalline silicon.

The second electrode 70 is stacked on the second unit cell 50.

As shown in Fig. 1, the photovoltaic device according to the embodiment of the present invention may further include a back reflector 60 between the second electrode 70 and the n-type layer 50n of the second unit cell 50, formed by CVD method in order to maximize light trapping effect.

Regarding the photovoltaic device according to the embodiment of the present invention, light is incident first on the substrate 10. The substrate 10 may include a transparent insulating material having an excellent optical transmittance and preventing internal short circuit in the photovoltaic device.

The first electrode 20 is required to scatter the incident light in various directions and have durability against hydrogen plasma for forming a microcrystalline silicon thin film. Therefore, the first electrode 20 may include a Zinc oxide (ZnO).

In the embodiment of the present invention, through radio frequency plasma enhanced chemical vapor deposition (RF PECVD) method using a frequency of 13.56 MHz or very high frequency (VHF) PECVD method using a frequency greater than 13.56 MHz, formed is the first unit cell 30 including the p-type window layer 30p, the i-type photoelectric conversion layer 30i and the n-type layer 30n. Since the RF PECVD and VHF PECVD use a high frequency, deposition rate is high and film quality is improved.

The intermediate reflector 40 may include a hydrogenated n-type micro crystalline silicon carbide or a hydrogenated n-type micro crystalline silicon nitride profiled such that carbon concentration or nitrogen concentration is higher the farther it is from a light incident side. The intermediate reflector 40 includes a hydrogenated n-type micro crystalline silicon carbide or a hydrogenated n-type micro crystalline silicon nitride which is formed in a post process.

The second unit cell 50 may be formed on the intermediate reflector 40 by RF PECVD method or VHF PECVD method and includes the p-type window layer 50p, the i-type photoelectric conversion layer 50i and the n-type layer 50n. Here, the second unit cell 50 may include microcrystalline silicon or amorphous silicon.

The back reflector 60 is formed on the n-type layer 50n of the second unit cell 50 by using CVD method and includes ZnO so as to maximize light trapping effect.

The second electrode 70 reflects the light which has transmitted through the second unit cell 50 back to the second unit cell 50, and functions as a back electrode in this embodiment. The second electrode 70 may include ZnO or Ag and may be formed by CVD method or sputtering method.

A patterning process is performed by using a pattern forming method such as a laser scribing so that unit cells are connected to each other in series during the production of a photovoltaic device. Such a patterning is performed on the first electrode 20, on the second unit cell 50 and on the second electrode 70.

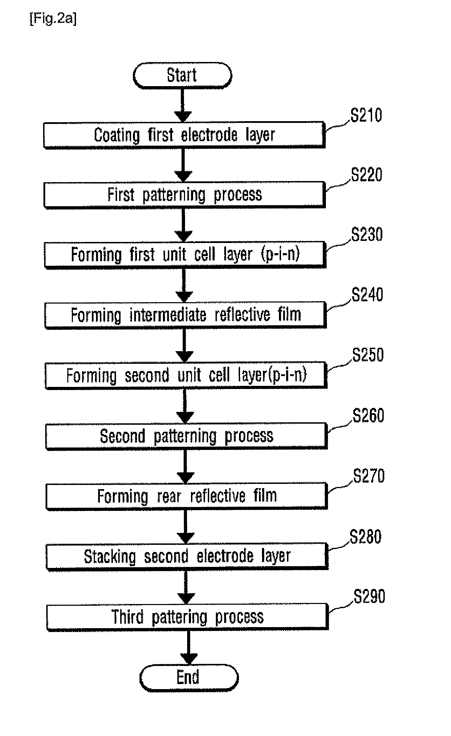

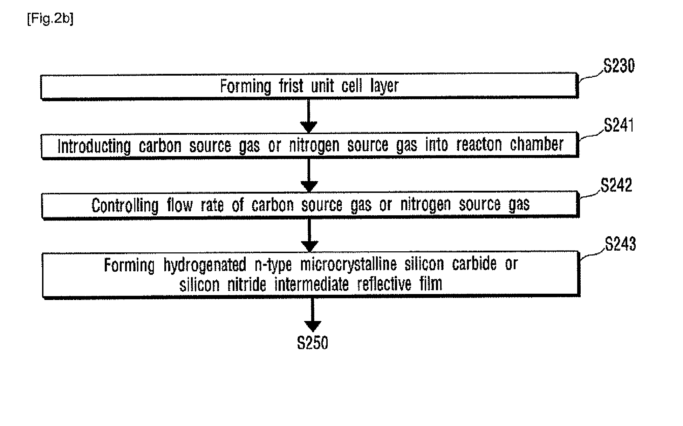

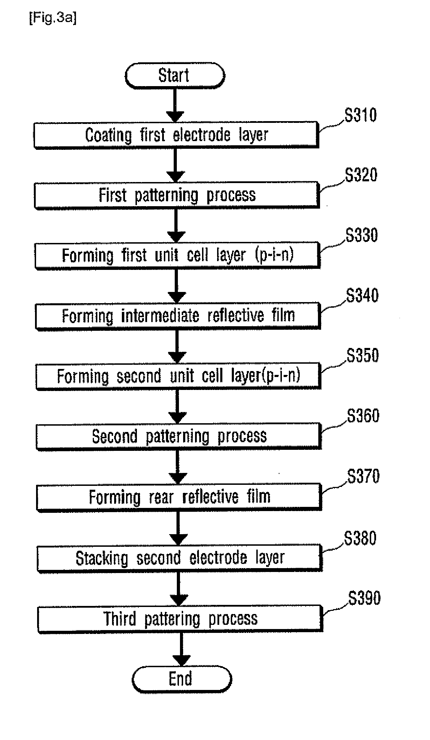

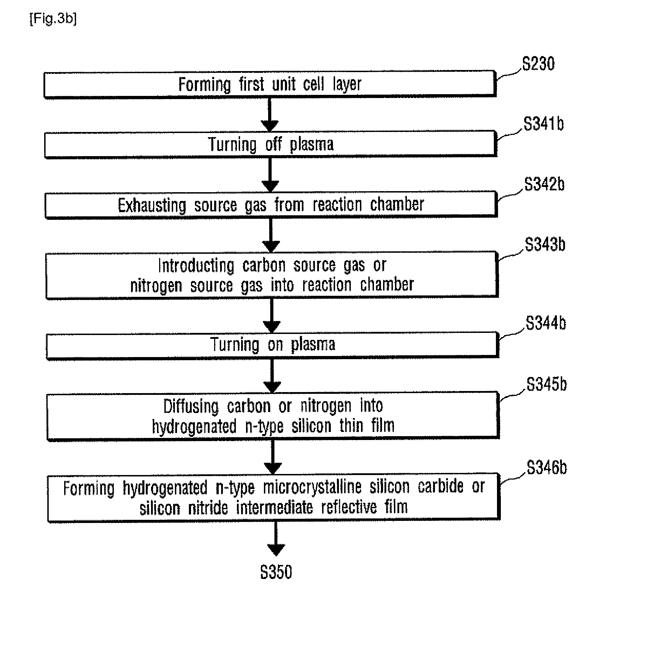

Next, a method for forming the intermediate reflector will be described in detail with reference to Figs. 2a, 2b, 3a and 3b. Figs. 2a and 2b are flowcharts showing a method for manufacturing a photovoltaic device according to the embodiment of the present invention.

As shown in Fig. 2a, a first electrode layer is coated on the substrate 10 (S210).

Through a first patterning process, some portions of the first electrode layer coated on the substrate 10 are removed and so separation grooves are formed. Accordingly, a plurality of first electrodes 20 are formed separately from each other (S220).

A first unit cell layer is formed on the plurality of the first electrodes 20 and in the separation grooves which are located between the first electrodes 20 (S230). The first unit cell layer includes a p-type window layer 30p, i-type photoelectric conversion layer 30i and n-type layer 30n.

An intermediate reflector 40 is formed on the first unit cell layer (S240). The intermediate reflector 40 includes a hydrogenated n-type microcrystalline silicon carbide or a hydrogenated n-type microcrystalline silicon nitride. The intermediate reflector 40 is profiled such that carbon concentration or nitrogen concentration is higher the farther it is from the substrate 10 by controlling a flow rate of carbon source gas or nitrogen source gas which is introduced into inside of a chamber. In the embodiment of the present invention, at least one of CH₄, C₂H₄ and C₂H₂ may be used as the carbon source gas. At least one of NH₄, N₂O and NO may be used as the nitrogen source gas.

A second unit cell layer is formed on the intermediate reflector 40 (S250). The second unit cell layer includes the p-type window layer 50p, the i-type photoelectric conversion layer 50i and the n-type layer 50n.

Through a second patterning process, some portions of the first unit cell layer and the second unit cell layer are removed and separation grooves are formed. Accordingly, the first unit cells 30 and the second unit cells 50 are formed (S260).

A second electrode layer is stacked on the second unit cells 50 and in the separation grooves formed through the second patterning process (S280).

Through a third patterning process, some portions of the second electrode layer are removed and separation grooves are formed. Accordingly a plurality of the second electrodes 70 are formed separately from each other (S290).

After the second patterning process, the back reflector 60 may be formed on the n-type layer 50n of the second unit cell layer by using CVD method in order to maximize the light trapping effect (S270).

For the sake of improving an initial efficiency, a buffer layer may be inserted between the p-type window layer 30p and the i-type photoelectric conversion layer 30i in the step of forming the first unit cell layer (S230),. The initial efficiency means the photoelectric conversion efficiency right after the time when a photovoltaic device is manufactured according to the embodiment of the present invention.

In the step S230 of forming the first unit cell layer, the first unit cell layer including p-i-n type thin film silicon is formed by using RF PECVD method or VHF PECVD method. The n-type layer 30n of the first unit cell 30 has a thickness which is equal to or more than 30 nm and equal to or less than 50 nm, and includes a hydrogenated n-type microcrystalline silicon (n-µc-Si:H) thin film. When the thickness of the n-type layer 30n of the first unit cell 30 is equal to or more than 30 nm, high electrical conductivity is obtained. When the thickness is equal to or less than 50 nm, it is possible to prevent excessive light absorption caused by the increase of the thickness.

Here, source gas for forming the hydrogenated n-type microcrystalline silicon (n-pc-Si:H) thin film may include SiH₄, H₂ and PH₃.

After forming the n-type layer 30n including the hydrogenated n-type microcrystalline silicon (n-pc-Si:H) thin film, as shown in Fig. 2b, carbon source gas or nitrogen source gas is introduced into a reaction chamber (S241a) under the condition that the flow rate, deposition temperature and deposition pressure and the like of source gas introduced into the reaction chamber are maintained.

Since the mixed gas including the source gas and the carbon source gas or the nitrogen source gas is introduced into the reaction chamber under the condition that the flow rate, deposition temperature and deposition pressure and the like of the source gas are maintained, the intermediate reflector 40 and the n-type layer 30n of the first unit cell layer may be formed within one reaction chamber.

In this case, the flow rate of the carbon source gas or the nitrogen source gas is controlled by a mass flow controller (MFC). That is, when the mixed gas in the reaction chamber has a constant flow rate, the mass flow controller is able to control the partial pressure of the carbon source gas or the nitrogen source gas in the mixed gas to be increased and then maintained constant in accordance with elapse of time.

As a result, the intermediate reflector 40 is formed on the first unit cell layer (S243a). The intermediate reflector 40 may include a hydrogenated n-type microcrystalline silicon carbide which is profiled such that carbon concentration is higher the farther it is from the substrate 10 or include a hydrogenated n-type microcrystalline silicon nitride which is profiled such that nitrogen concentration is higher the farther it is from the substrate 10.

The intermediate reflector 40 including a hydrogenated n-type microcrystalline silicon carbide or a hydrogenated n-type microcrystalline silicon nitride is formed(S243a) while the mass flow controller increases the flow rate of the carbon source gas or the nitrogen source gas stepwise in accordance with elapse of time (S242a). Accordingly, the hydrogenated n-type microcrystalline silicon carbide or the hydrogenated n-type microcrystalline silicon nitride of the intermediate reflector 40 is profiled such that carbon concentration or nitrogen concentration is higher the farther it is from the substrate 10.

The thickness of the intermediate reflector 40 may be equal to or more than 10 nm and equal to or less than 120 nm. When the thickness of the intermediate reflector 40 is equal to or more than 10 nm, visible rays are internally reflected enough. When the thickness of the intermediate reflector 40 is equal to or less than 120 nm, sufficient amount of light is delivered from the first unit cell 30 to the second unit cell 50 and it is possible to prevent the light from being absorbed by the intermediate reflector 40 and to prevent series resistance between the first unit cell 30 and the second unit cell 50 from unnecessarily increasing.

The intermediate reflector 40 according to the embodiment of the present invention has a resistivity which is equal to or more than 102 Ω·cm and equal to or less than 105 Ω·cm. When light is incident on the intermediate reflector 40, the intermediate reflector 40 may have a refractive index which is equal to or more than 1.7 and equal to or less than 2.2. Therefore, the intermediate reflector 40 has a high vertical electrical conductivity. When the refractive index of the intermediate reflector 40 is equal to or more than 1.7, the conductivity thereof increases, a multi junction photovoltaic device is improved in view of a fill factor (FF) and it can achieve a high efficiency. When the refractive index of the intermediate reflector 40 is equal to or less than 2.2, light having a wavelength from 500 nm to 700 nm is easily reflected so that the short circuit current of the first unit cell 30 increases. As a result, efficiency of the photovoltaic device is enhanced.

As described in the embodiment of the present invention, since the intermediate reflector 40 is profiled such that the farther it is from the substrate 10, the higher carbon concentration or nitrogen concentration is, the crystal volume fraction thereof is prevented from being rapidly reduced and the vertical electrical conductivity is prevented from being rapidly degraded. Further, an optical band gap or a refractive index in the interface between the n-type layer 30n and the intermediate reflector 40 smoothly changes, that is, they do not undergo abrupt transition in the boundary. Accordingly, it prevents defect density from being rapidly increased in the hetero-junction boundary between the intermediate reflector 40 and the n-type layer 30n of the first unit cell layer. As a result, the light absorption by the intermediated reflector 40 can be minimized.

Figs. 3a and 3b are flowcharts showing a method for manufacturing the photovoltaic device according to another embodiment of the present invention.

As shown in Figs. 3a and 3b, a first electrode layer is coated on a substrate 10 (S310).

Through a first patterning process, some portions of the first electrode layer are removed and separation grooves are formed. Accordingly, a plurality of first electrodes 20 are formed (S220).

A first unit cell layer is formed on the plurality of the first electrodes 20 and in the separation grooves which are located between the first electrodes 20 (S330). The first unit cell layer includes the p-type window layer 30p, the i-type photoelectric conversion layer 30i and the n-type layer 30n.

The intermediate reflector 40 including a hydrogenated n-type microcrystalline silicon carbide or a hydrogenated n-type microcrystalline silicon nitride is formed on the n-type layer 30n including microcrystalline silicon (n-pc-Si:H) (S340) by diffusing carbon atoms or nitrogen atoms, which are decomposed from the carbon source gas or the nitrogen source gas respectively by plasma, into the n-type layer 30n. In other words, the intermediate reflector 40 is formed by diffusing carbon or nitrogen into the n-type layer 30n of the first unit cell layer.

In the step (S340), if n-type doping gas such as PH₃ is mixed with the carbon source gas or the nitrogen source gas, high conductive intermediate reflector including a hydrogenated n-type microcrystalline silicon carbide or a hydrogenated n-type microcrystalline silicon nitride is formed by the diffusion of the n-type doping gas.

Since crystal volume fraction of nitrogen and carbon is higher than that of oxygen, the vertical electrical conductivity of the intermediate reflector is enhanced and more roughness of the intermediate reflector 40 is formed.

A second unit cell layer is formed on the intermediate reflector 40 (S350). The second unit cell layer includes the p-type window layer 50p, the i-type photoelectric conversion layer 50i and the n-type layer 50n.

Through a second patterning process, some portions of the first unit cell layer and the second unit cell layer are removed and separation grooves are formed. Accordingly, the first unit cells 30 and the second unit cells 50 are formed (S360).

A second electrode layer is stacked on the second unit cells 50 and in the separation grooves formed through the second patterning process (S380).

Through a third patterning process, some portions of the second electrode layer are removed and separation grooves are formed. Accordingly a plurality of the second electrodes 70 are formed separately from each other (S390).

After the second patterning process, the back reflector 60 may be formed on the n-type layer 50n of the second unit cell layer by using CVD method in order to maximize the light trapping effect (S370).

For the sake of improving an initial efficiency, a buffer layer may be introduced between the p-type window layer 30p and the i-type photoelectric conversion layer 30i in the step of forming the initial unit cell layer (S330).

When the first unit cell layer including p-i-n type thin film silicon is formed by using RF PECVD method or VHF PECVD method, the n-type layer 30n of the first unit cell layer has a thickness which is equal to or more than 40 nm and equal to or less than 150 nm, and includes a hydrogenated n-type microcrystalline silicon (n-pc-Si:H). Source gas for forming the n-type layer 30n of the first unit cell layer may include SiH₄, H₂ and PH₃.

The thickness of the intermediate reflector 40 formed by diffusing carbon or nitrogen may be equal to or more than 10 nm and equal to or less than 120 nm. When light from the first unit cell 30 is incident on the intermediate reflector 40, the intermediate reflector 40 may have a refractive index which is equal to or more than 1.7 and equal to or less than 2.2. Therefore, the intermediate reflector 40 has a high vertical electrical conductivity. When the refractive index of the intermediate reflector 40 is equal to or more than 1.7, the conductivity thereof increases, a multi junction photovoltaic device is improved in view of a fill factor (FF) and it can achieve a high efficiency. When the refractive index of the intermediate reflector 40 is equal to or less than 2.2, light of a wavelength from 500 nm to 700 nm is easily reflected so that the short circuit current of the first unit cell 30 increases. As a result, efficiency of the photovoltaic device is enhanced.

Meanwhile, as shown in Fig. 3b, deposition process of the hydrogenated n-type microcrystalline silicon (n-pc-Si:H) thin film ends when plasma is turned off (S341b), that is, plasma generation stops. After finishing the deposition process of the hydrogenated n-type microcrystalline silicon (n-pc-Si:H) thin film, the source gas is exhausted from the reaction chamber in a state where the deposition temperature is maintained (S342b).

After exhausting the source gas, post processing base pressure of the inside of a deposition chamber may be equal to or more than 10⁻⁷ Torr and equal to or less than 10⁻⁵ Torr. Post processing pressure of the reaction chamber is maintained constant by a pressure controller and an angle valve which are connected to the reaction chamber. After the pressure of the deposition chamber reaches the post processing base pressure, carbon source gas or nitrogen source gas is injected into the reaction chamber (S343b). Here, the n-type doping gas may be also introduced.

The flow rate of the carbon source gas or the nitrogen source gas may be gradually increased and then maintained constant, or increased stepwise. The flow rate of the carbon source gas or the nitrogen source gas introduced into the reaction chamber may be equal to or more than 10 sccm and equal to or less than 500 sccm. The pressure of the reaction chamber may be equal to or more than 0.5 Torr and equal to or less than 10 Torr. When the flow rate of the carbon source gas or the nitrogen source gas is equal to or more than 10 sccm, carbon or nitrogen diffusion rate increases. When the flow rate of the carbon source gas or the nitrogen source gas is equal to or less than 500 sccm, it prevents gas cost from being unnecessarily increased. Also, when the pressure of the reaction chamber is between 0.5 Torr and 10 Torr, it is possible to obtain an appropriate carbon diffusion rate or an appropriate nitrogen diffusion rate but also to prevent the gas cost from being increased.

By turning on plasma (S344b), that is, by generating plasma, the carbon source gas or the nitrogen source gas is decomposed so that carbon atoms or nitrogen atoms are generated. When carbon or nitrogen is diffused through the surface of the hydrogenated n-type micro crystalline silicon (n-µc-Si:H) thin film of the n-type layer 30n by the carbon atoms or the nitrogen atoms (S345b), the intermediate reflector 40 including the hydrogenated n-type microcrystalline silicon carbide or the hydrogenated n-type microcrystalline silicon nitride is formed on the hydrogenated n-type micro crystalline silicon (n-pc-Si:H) thin film of the n-type layer 30n (S346b).

In the embodiments of Figs. 3a and 3b, after forming the hydrogenated n-type microcrystalline silicon, the intermediate reflector 40 is formed by a process of diffusing carbon or nitrogen. Therefore, after finishing the diffusion process, the thickness of the hydrogenated n-type micro crystalline silicon (n-µc-Si:H) thin film is reduced by as much as the thickness of the intermediate reflector 40. The thicker the hydrogenated n-type microcrystalline silicon (n-µc-Si:H) thin film is, the more a crystal volume fraction increases and the more the vertical electrical conductivity increases. In the embodiment of the present invention, a property of the hydrogenated n-type microcrystalline silicon (n-pc-Si:H) having high crystal volume fraction is used, in which carbon or nitrogen passes through grain boundaries and tends to diffuse.

Through the diffusion process, part of the hydrogenated n-type microcrystalline silicon (n-µc-Si:H) thin film is converted into the intermediate reflector 40 including the hydrogenated n-type microcrystalline silicon carbide or the hydrogenated n-type microcrystalline silicon nitride. As a result, the vertical electrical conductivity is prevented from being rapidly degraded and the refractive index is reduced.

Meanwhile, in the method for manufacturing the photovoltaic device according to the embodiments shown in Figs. 2a to 3b, the first patterning process to the third patterning process are performed by using a laser scribing method and the like in order to connect the unit cells in series.

Therefore, each unit cell and the intermediate reflector are simultaneously patterned by means of a laser with the same wavelength so as to form a large area photovoltaic device module. As a result, it allows to increase production yield of a photovoltaic device and to make layout of production line simple.

In the embodiment of the present invention, the p-type window layers 30p and 50p are doped with impurities such as group 3 elements. The i-type photoelectric conversion layers 30i and 50i are intrinsic silicon layers. The n-type layers 30n and 50n are doped with impurities such as group 5 elements.

From now on, as an example according to the embodiments of the present invention, a photovoltaic device having a p-i-n-p-i-n type double junction structure or a p-i-n-p-i-n-p-i-n type triple junction structure will be described.

In the case of the double junction thin film silicon photovoltaic device, an intermediate reflector is formed between the first unit cell and the second unit cell. The intermediate reflector includes a hydrogenated n-type microcrystalline silicon carbide or a hydrogenated n-type micro crystalline silicon nitride, and has a refractive index which is equal to or more than 1.7 and equal to or less than 2.2.

In the double junction photovoltaic device, the i-type photoelectric conversion layer 30i of the first unit cell 30 may include any one of a group of a hydrogenated intrinsic amorphous silicon (i-a-Si:H), a hydrogenated intrinsic proto crystalline silicon (i-pc-Si:H), a hydrogenated intrinsic proto crystalline silicon (i-pc-Si:H) multilayer, a hydrogenated intrinsic amorphous silicon carbide (i-pc-SiC:H), a hydrogenated intrinsic proto crystalline silicon carbide (i-pc-SiC:H), a hydrogenated intrinsic proto crystalline silicon carbide (i-pc-SiC:H) multilayer, a hydrogenated intrinsic amorphous silicon oxide (i-a-SiO:H), a hydrogenated intrinsic proto crystalline silicon oxide (i-pc-SiO:H) or a hydrogenated intrinsic proto crystalline silicon oxide (i-pc-SiO:H) multilayer.

Further, in the double junction photovoltaic device, the i-type photoelectric conversion layer 50i of the second unit cell 50 may include any one of a group of a hydrogenated intrinsic amorphous silicon (i-a-Si:H), a hydrogenated intrinsic amorphous silicon germanium (i-a-SiGe:H), a hydrogenated intrinsic proto crystalline silicon germanium (i-pc-SiGe:H), a hydrogenated intrinsic nanocrystalline silicon (i-nc-Si:H), a hydrogenated intrinsic micro crystalline silicon (i-µc-Si:H) or a hydrogenated intrinsic micro crystalline silicon germanium (i-µc-SiGe:H).

Meanwhile, in the case of the p-i-n-p-i-n-p-i-n type triple junction photovoltaic device, the first unit cell or the second unit cell may be located in the middle of three unit cells of the triple junction photovoltaic device. If the first unit cell is located in the middle of three unit cells, the second unit cell is located to contact with or to be adjacent to the second electrode of the triple junction photovoltaic device. Further, if the second unit cell is located in the middle of three unit cells, the first unit cell is located to contact with or to be adjacent to the first electrode of the triple junction photovoltaic device.

When the second unit cell is located in the middle of three unit cells, an intermediate reflector is formed between the first unit cell and the second unit cell. The intermediate reflector includes a hydrogenated n-type microcrystalline silicon carbide or a hydrogenated n-type microcrystalline silicon nitride, and has a refractive index which is equal to or more than 1.7 and equal to or less than 2.2. Moreover, an intermediate reflector may be formed in every place between any two adjacent unit cells among three unit cells. The intermediate reflector includes a hydrogenated n-type microcrystalline silicon carbide or a hydrogenated n-type microcrystalline silicon nitride, and has a refractive index which is equal to or more than 1.7 and equal to or less than 2.2.

In the triple junction photovoltaic device, the i-type photoelectric conversion layer of the unit cell contacting with or adjacent to the first electrode may include any one of a group of a hydrogenated intrinsic amorphous silicon (i-a-Si:H), a hydrogenated intrinsic proto crystalline silicon (i-pc-Si:H), a hydrogenated intrinsic proto crystalline silicon (i-pc-Si:H) multilayer, a hydrogenated intrinsic amorphous silicon carbide (i-pc-SiC:H), a hydrogenated intrinsic proto crystalline silicon carbide (i-pc-SiC:H), a hydrogenated intrinsic proto crystalline silicon carbide (i-pc-SiC:H) multilayer, a hydrogenated intrinsic amorphous silicon oxide (i-a-SiO:H), hydrogenated intrinsic proto crystalline silicon oxide (i-pc-SiO:H) or a hydrogenated intrinsic proto crystalline silicon oxide (i-pc-SiO:H) multilayer.

The i-type photoelectric conversion layer of the unit cell located in the middle of the triple junction photovoltaic device includes a hydrogenated intrinsic amorphous silicon germanium (i-a-SiGe:H), a hydrogenated intrinsic proto crystalline silicon germanium (i-pc-SiGe:H), a hydrogenated intrinsic nanocrystalline silicon (i-nc-Si:H), a hydrogenated intrinsic micro crystalline silicon (i-µc-Si:H), a hydrogenated intrinsic micro crystalline silicon germanium carbon (i-µc-SiGeC:H) and the like. An intrinsic light absorbing layer of a unit cell contacting with or adjacent to the first electrode below the middle unit cell may include any one of a group of a hydrogenated intrinsic amorphous silicon germanium (i-a-SiGe:H), a hydrogenated intrinsic proto crystalline silicon germanium (i-pc-SiGe:H), a hydrogenated intrinsic nanocrystalline silicon (i-nc-Si:H), a hydrogenated intrinsic micro crystalline silicon (i-µc-Si:H) or a hydrogenated intrinsic micro crystalline silicon germanium (i-µc-SiGe:H).

The p-i-n type photovoltaic device on which light is incident in the direction from the first unit cell 30 formed on the substrate 10 to the second unit cell 50 has been described in the embodiment of the present invention. Moreover, the present invention may be applied to n-i-p type photovoltaic device on which light is incident from the opposite side to the substrate 10, that is, in the direction from the second unit cell 50 to the first unit cell 30.

In other words, light is incident on the n-i-p type photovoltaic device from the side of the second unit cell opposite to the substrate 10, that is, in the direction from the second unit cell 50 to the first unit cell 30. A first unit cell 30' including sequentially stacked n-type layer 30n', i-type photoelectric conversion layer 30i' and p-type window layer 30p' is formed on a first electrode 20. An intermediate reflector 40 is formed on the first unit cell 30'. A second unit cell 50' including sequentially stacked n-type layer 50n', i-type photoelectric conversion layer 50i' and p-type window layer 50p' is formed on the intermediate reflector 40.

The intermediate reflector 40 is required to match refractive index to the second unit cell 50' from which light is incident. The intermediate reflector 40 contacts with the n-type layer of the second unit cell 50'. Therefore, after the p-type window layer 30p' of the first unit cell 30' is formed, the intermediate reflector 40 including the hydrogenated n-type microcrystalline silicon carbide or the hydrogenated n-type microcrystalline silicon nitride is formed. Here, the intermediate reflector 40 according to the embodiment of the present invention may be profiled such that carbon concentration or nitrogen concentration is higher the farther it is from the light incident side, in this case, the second unit cell 50'.

Meanwhile, the photovoltaic device according to the embodiments of the present invention includes the intermediate reflector 40 so as to improve the efficiency of a tandem structure including a plurality of unit cells. It is possible to provide an even better efficiency by controlling the electric current of the plurality of the unit cells in addition to introducing the intermediate reflector 40.

In general, the operating temperature of the photovoltaic device is an important factor in designing current matching among the plurality of the unit cells of the photovoltaic device having a tandem structure.

For example, a photovoltaic device installed in a region having high temperature or strong ultraviolet radiation is designed such that short circuit current of the photovoltaic device is determined by the short circuit current of the unit cell which is closest to the light incident side among the unit cells of the photovoltaic device. This is because the photovoltaic device having its short circuit current determined by the short circuit current of the unit cell which is closest to the light incident side has low temperature coefficient (i.e., an efficiency deterioration rate of the photovoltaic device according to temperature rise by 1 °C). That is, the temperature rise of the photovoltaic device has small influence on the efficiency deterioration thereof.

On the other hand, a photovoltaic device installed in a region having low temperature or small amount of ultraviolet radiation is designed such that short circuit current of the photovoltaic device is determined by short circuit current of the unit cell which is farthest from the light incident side among the unit cells of the photovoltaic device. Even though the photovoltaic device having its short circuit current determined by the short circuit current of the unit cell which is farthest from the light incident side has high temperature coefficient (i.e., an efficiency deterioration rate of the photovoltaic device according to a temperature rise by 1 °C), it has low degradation ratio. Since the photovoltaic device installed in a low temperature region is relatively less affected by the temperature coefficient, the photovoltaic device is designed such that the short circuit current of the photovoltaic device is determined by the short circuit current of the unit cell which is farthest from the light incident side.

A rated output (efficiency) of the photovoltaic device designed in this manner is measured indoors under standard test conditions (hereinafter, referred to as STC). The set of STC consists of the followings.
AM 1.5 (AIR MASS 1.5)
Irradiance: 1000 W·m⁻²
Photovoltaic cell Temperature: 25 °C

However, when a photovoltaic device is installed outdoors, it happens that the temperature of the photovoltaic device is higher than 25 °C. In this case, due to the temperature coefficient of the photovoltaic device, the efficiency of the photovoltaic device becomes lower than the rated efficiency of the photovoltaic device measured under the STC.

That is, when the photovoltaic device is operating, most of light energy absorbed by the photovoltaic device is converted into heat energy. An actual operating temperature of the photovoltaic device hereby easily becomes higher than 25 °C, i.e., the photovoltaic cell temperature under the STC. Accordingly, the temperature coefficient of the photovoltaic device causes the efficiency of the photovoltaic device to be lower than the rated efficiency of the photovoltaic device measured under the STC.

Because of such problems, when current matching design in the photovoltaic device having a tandem structure is performed on the basis of 25 °C, i.e., the photovoltaic cell temperature of the STC, the photovoltaic device may not achieve a desired efficiency.

Accordingly, current matching design of the photovoltaic device according to the embodiment of the present invention is performed under a nominal operating cell temperature obtained in a standard reference environment which is similar to the actual condition under which the photovoltaic device is installed. The set of standard reference environment includes the followings.
Tilt angle of photovoltaic device: 45° from the horizon
Total irradiance: 800 W·m⁻²
Circumstance temperature: 20 °C
Wind speed: 1m·s⁻¹
Electric load: none (open state)

The nominal operating cell temperature corresponds to a temperature at which the photovoltaic device mounted on an open rack operates under the standard reference environment. The photovoltaic device is used in a variety of actual environments. Therefore, when designing the current matching of the photovoltaic device having a tandem structure is performed under nominal operating cell temperature measured in the standard reference environment which is similar to the condition under the photovoltaic device is actually installed, it is possible to manufacture the photovoltaic device suitable for the actual installation environment. By controlling the thicknesses and optical band gaps of the i-type photoelectric conversion layers of the first unit cells 30 and 30' and the second unit cells 50 and 50' such that the short circuit currents of the first unit cells 30 and 30' and the second unit cells 50 and 50' are controlled, the efficiency of the photovoltaic device may be enhanced.

For this reason, in the embodiment of the present invention, when the nominal operating cell temperature of the photovoltaic device is equal to or more than 35 degrees Celsius, the thickness and optical band gap of the i-type photoelectric conversion layer of one unit cell which is closest to the light incident side between the first unit cell 30 and 30' and the second unit cell 50 and 50' is set such that the short circuit current of the one unit cell is equal to or less than that of the other unit cell. As a result, the short circuit current of the photovoltaic device according to the embodiment of the present invention is determined by the short circuit current of the unit cell which is closest to the light incident side.

As such, when the short circuit current of one unit cell which is closest to the light incident side is equal to or less than that of the other unit cell, the temperature coefficient becomes smaller. Therefore, although the actual temperature of the photovoltaic device becomes higher, electricity generation performance decrease due to the efficiency deterioration is reduced. For example, when the photovoltaic device designed for making the short circuit current of one unit cell which is closest to the light incident side to be equal to or less than the short circuit current of the other unit cell is installed in a region having high temperature or strong ultraviolet rays of sunlight including intensive short wavelength rays in a blue-color range, the temperature coefficient is small. Therefore, although the actual temperature of the photovoltaic device becomes higher, the electricity generation performance decrease due to the efficiency degradation is reduced.

Contrary to this, when the nominal operating cell temperature of the photovoltaic device is less than and not equal to 35 degrees Celsius, the thicknesses and optical band gap of the i-type photoelectric conversion layer of one unit cell which is farthest from the light incident side between the first unit cell 30 and 30' and the second unit cell 50 and 50' is set such that the short circuit current of the other unit cell which is closest to the light incident side is equal to or less than that of the one unit cell. In other words, when the nominal operating cell temperature of the photovoltaic device is less than and not equal to 35 degrees Celsius, the thickness and optical band gap of the i-type photoelectric conversion layer of one unit cell which is closest to the light incident side between the first unit cell 30 and 30' and the second unit cell 50 and 50' is determined such that the short circuit current of the other unit cell is equal to or more than that of the one unit cell.

A resulting short circuit current of the photovoltaic device according to the embodiment of the present invention is hereby determined by the short circuit current of the unit cell which is farthest from the light incident side between the first unit cell and the second unit cell. In this case, even though temperature coefficient of the photovoltaic device is high, degradation ratio of the photovoltaic device is reduced. Since the actual operating temperature of the photovoltaic device is relatively low, the electricity generation performance may be improved in that the performance improvement due to the low degradation ratio may overtake the performance deterioration due to the high temperature coefficient. Particularly, because the degradation rate in fill factor is small, the photovoltaic device has an excellent outdoor electricity generation performance in an environment having a circumference temperature lower than 25 °C, i.e., the STC.

As described in the embodiment, regarding the photovoltaic device of which current matching design is performed under the nominal operating cell temperature, the short circuit current of the photovoltaic device can be measured under the STC.

The larger the thickness of the i-type photoelectric conversion layer is and the less the optical band gap of the i-type photoelectric conversion layer is, the bigger the short circuit current of the unit cell is. Accordingly, the short circuit current can be controlled by the determination of the thickness and the optical band gap of the i-type photoelectric conversion layer.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

## Claims

1. A photovoltaic device comprising:
a substrate (10);
a first unit cell (30) disposed on the substrate (10) and comprising a p-type window layer (30p), an i-type photoelectric conversion layer (30i) and an n-type layer (30n);
an intermediate reflector (40) disposed on the first unit cell (30); and
a second unit cell (50) disposed on the intermediate reflector (40) and
comprising a p-type window layer (50p), an i-type photoelectric conversion layer (50i) and an n-type layer (50n),
wherein the intermediate reflector (40) comprises a hydrogenated n-type microcrystalline silicon carbide or a hydrogenated n-type microcrystalline silicon nitride profiled such that carbon concentration or nitride concentration is higher the farther it is from a light incident side.

2. The photovoltaic device according to claim 1, wherein a thickness of the intermediate reflector (40) is equal to or more than 10 nm and equal to or less than 120 nm.

3. The photovoltaic device according to claim 1, wherein a refractive index of the intermediate reflector (40) is equal to or more than 1.7 and equal to or less than 2.2 in a wavelength range from 500nm to 700nm,.

4. The photovoltaic device according to claim 1, wherein the n-type layer (30n) of the first unit cell (30) includes a hydrogenated n-type microcrystalline silicon.

5. The photovoltaic device according to claim 1, wherein the first unit cell (30) includes a hydrogenated amorphous silicon.

6. The photovoltaic device according to claim 1, wherein the second unit cell (50) includes a hydrogenated amorphous silicon or a hydrogenated microcrystalline silicon.

7. The photovoltaic device according to claim 1, further comprising a back reflector (60) disposed on the second unit cell (50).

8. The photovoltaic device according to claim 1, wherein the n-type layer (30n) of the first unit cell (30) has a thickness which is equal to or more than 30 nm and equal to or less than 50 nm.

9. The photovoltaic device according to claim 1, wherein the light is incident in a direction from the first unit cell (30) to the second unit cell (50) or from the second unit cell (50) to the first unit cell (30).

10. The photovoltaic device according to claim 1, **characterized in that**, when nominal operating cell temperature of the photovoltaic device is equal to or more than 35 degrees Celsius, a short circuit current of one unit cell which is closest to the light incident side between the first unit cell (30) and the second unit cell (50) is equal to or less than that of the other unit cell.

11. The photovoltaic device according to claim 1, **characterized in that**, when nominal operating cell temperature of the photovoltaic device is less than and not equal to 35 degrees Celsius, a short circuit current of one unit cell which is closest to the light incident side between the first unit cell (30) and the second unit cell (50) is equal to or more than that of the other unit cell.

12. A method for manufacturing a photovoltaic device, the method comprising:
(S220) forming a plurality of first electrodes (20) on a substrate (10);
(S230) forming a first unit cell layer (30) comprising a p-type window layer (30p), an i-type photoelectric conversion layer (30i) and an n-type layer (30n) on the plurality of the first electrodes (20);
(S240) forming an intermediate reflector (40) on the first unit cell layer (30);
and
(S250) forming a second unit cell layer (50) on the intermediate reflector (40),
wherein the intermediate reflector (40) comprises a hydrogenated n-type microcrystalline silicon carbide or a hydrogenated n-type microcrystalline silicon nitride profiled such that carbon concentration or nitride concentration is higher the farther it is from a light incident side.

13. The method according to claim 12, wherein the step (S240) forming the intermediate reflector (40) comprises diffusing carbon or nitrogen into the n-type layer (30n) of the first unit cell layer (30).

14. The method according to claim 12 or 13, wherein carbon source gas for forming the intermediate reflector (40) includes at least one of CH₄, C₂H₄ or C₂H₂, and nitrogen source gas for forming the intermediate reflector (40) includes at least one of NH₄, N₂O or NO.

15. The method according to claim 12 or 13, further comprising a step (S270) forming a back reflector (60) on the second unit cell layer (50).

16. The method according to claim 12, wherein the n-type layer (30n) of the first unit cell layer (30) has a thickness which is equal to or more than 30 nm and equal to or less than 50 nm and includes a hydrogenated n-type microcrystalline silicon.

17. The method according to claim 13, wherein the n-type layer (30n) of the first unit cell layer (30) has a thickness which is equal to or more than 40 nm and equal to or less than 150 nm before the diffusion of the carbon or the nitrogen, and includes a hydrogenated n-type micro crystalline silicon.

18. The method according to claim 12, wherein the step (S240) forming the intermediate reflector (40) on the first unit cell layer (30) is performed under the same deposition temperature and deposition pressure as those of source gas for forming the n-type layer (30n) of the first unit cell layer (30).

19. The method according to claim 18, wherein the intermediate reflector (40) and the n-type layer (30n) of the first unit cell layer (30) are formed in one reaction chamber.

20. The method according to claim 12 or 13, wherein the step (S240) forming the intermediate reflector (40) comprises increasing or decreasing a flow rate of carbon source gas or nitrogen source gas in accordance with elapse of time.

21. The method according to claim 13, wherein the step (S230) forming the first unit cell layer (30) ends by (S341b) turning off plasma for forming the n-type layer (30n) of the first unit cell layer (30), and the step (S240) forming the intermediate reflector (40) starts by (S344b) turning on the plasma after (S343b) introducing carbon source gas or nitrogen source gas for forming the intermediate reflector (40).

22. The method according to claim 22, further introducing n-type doping gas in addition to the carbon source gas or the nitrogen source gas.
